**Europäisches Patentamt**

**European Patent Office**

**Office européen des brevets**

(19)

(11) Numéro de publication: **0 186 543**
**B1**

(12) # FASCICULE DE BREVET EUROPEEN

(45) Date de publication du fascicule du brevet:
**24.05.89**

(51) Int. Cl.⁴: **H 05 K 5/02**

(21) Numéro de dépôt: **85402259.7**

(22) Date de dépôt: **20.11.85**

(54) **Dispositif de mise à l'atmosphère pour boîtier électronique.**

(30) Priorité: **29.11.84 FR 8418163**

(43) Date de publication de la demande:
**02.07.86 Bulletin 86/27**

(45) Mention de la délivrance du brevet:
**24.05.89 Bulletin 89/21**

(84) Etats contractants désignés:
**DE GB IT SE**

(56) Documents cités:
**FR-A- 2 500 713**
**GB-A- 2 047 470**
**US-A- 3 336 457**

(73) Titulaire: **Bendix Electronics S.A., Avenue du Mirail, B.P. 1149, F-31036 Toulouse Cédex (FR)**

(72) Inventeur: **Vincent, Jacques, Le Montat, F-46000 Cahors (FR)**

(74) Mandataire: **Colas, Jean-Pierre et al, Cabinet de Boisse 37, avenue Franklin D. Roosevelt, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

# Description

La présente invention se rapporte à un dispositif de mise à l'atmosphère de l'intérieur d'un boîtier électronique, notamment pour utilisation sur des véhicules automobiles conçu de manière à permettre le passage de l'air tout en interdisant celui de l'eau.

La réalisation d'un boîtier électronique totalement étanche est un problème difficile et coûteux. Pour les applications automobiles, les problèmes de coût étant prépondérants, il n'est pas toujours possible de réaliser des boîtiers électroniques totalement étanches.

Néanmoins, ces boîtiers doivent pouvoir fonctionner dans les conditions sévères d'environnement rencontrées dans le compartiment moteur d'un véhicule: aspersion d'eau, variations rapides de températures, etc.

Le problème posé par un boîtier non parfaitement étanche est le suivant: un boîtier chaud aspergé d'eau fraiche est brutalement refroidi, ce qui a pour effet de créer une dépression à l'intérieur de ce boîtier d'où il résulte une aspiration d'air et éventuellement d'eau, de poussières, etc.

Une solution connue consiste à concevoir un boîtier électronique relativement étanche et à pratiquer dans une paroi de ce boîtier une ouverture controlée.

A cet effet, certain boîtiers sont dotés d'un simple orifice dans une paroi abritée des aspersions directes d'eau.

Cependant, l'eau qui ruisselle peut facilement s'introduire dans le boîtier et provoquer des courts-circuits entre les différents composants sous tension.

Une autre solution consiste à rapporter une chicane de matière plastique dans l'orifice d'une paroi du boîtier. Dans ce cas, les gouttes d'eau peuvent glisser sur cette paroi sans pénétrer dans l'orifice grâce à la chicane, mais celle-ci n'est pas un barrage à l'aspersion directe d'eau.

Un feutre siliconé maintenu en place par une pièce emmanchée à force dans une paroi du boîtier à protéger est un écran efficace à l'aspersion directe d'eau mais cette solution reste coûteuse.

Un dispositif de mise à l'atmosphère selon le préambule de la revendication 1 est aussi connu d'après le US-A-3 336 457.

La présente invention a pour but de fournir un dispositif qui constitue un barrage efficace à l'aspersion d'eau sur un boîtier électronique, tout en présentant un faible coût et en étant d'un assemblage aisé et rapide.

A cet effet, l'invention a pour objet un dispositif de mise à l'atmosphère pour un boîtier électronique, comprenant un passage ménagé dans une paroi du boîtier et mettant en communication l'intérieur et l'extérieur du boîtier et un filtre reçu dans ledit passage, caractérisé en ce qu'il comprend également une rainure périphérique de canalisation de liquide ménagée dans la face extérieure de la paroi et entourant complètement ledit passage.

De préférence, le filtre est constitué d'un matériau métallique poreux obtenu par exemple par frittage d'une poudre métallique telle que le bronze ou l'acier inoxydable.

La rainure périphérique ménagée dans la paroi permet de dévier l'eau qui ruisselle éventuellement sur le boîtier, sans que celle-ci touche le filtre qui ne requiert donc pas des caractéristiques d'étanchéité à l'eau sévères.

De préférence, le passage comprend un logement dans lequel le filtre est emmanché à force et un orifice ménagé entre le fond du logement et l'intérieur du boîtier. Le logement, l'orifice et la rainure peuvent être obtenus lors du moulage du boîtier. Le montage en force du filtre dans le logement est simple et rapide. l'ensemble a donc pour avantage un coût global de fabrication relativement bas.

D'autres caractéristiques et avantages de l'invention ressortiront de la description qui va suivre d'un mode de sa réalisation donné uniquement à titre d'exemple et illustré par les dessins annexés sur lesquels:

– la figure 1 est une vue extérieure en perspective d'un dispositif de mise à l'atmosphère équipant une paroi de boîtier électronique,

– la figure 2 est une vue en coupe axiale du dispositif de mise à l'atmosphère de la figure 1,

– la figure 3 est une vue en perspective du filtre faisant partie du dispositif des figures 1 et 2.

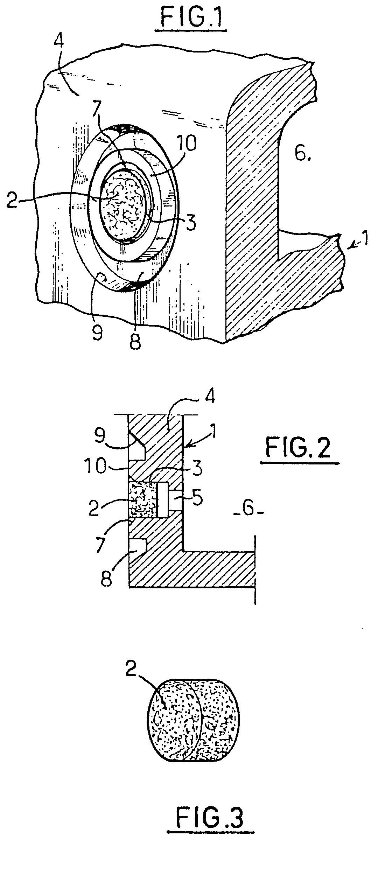

En se reportant aux figures 1 et 2, le dispositif de mise à l'atmosphère équipant un boîtier électronique 1 en matière plastique ou métallique comprend un filtre 2 emmanché à force dans un logement 3 ménagé dans la face extérieure d'une paroi latérale 4 du boîtier 1. Le fond du logement 3 communique par un orifice 5 avec le volume intérieur 6 du boîtier 1. Le bord du logement 3 présente de préférence un chanfrein 7 facilitant la mise en place du filtre 2 et, accessoirement, l'écoulement d'eau autour de l'extrémité du filtre en cas d'aspersion directe de ce dernier. D'une façon préférentielle la paroi 4 est disposée dans une position sensiblement verticale lorsque le boîtier mis en place en condition d'utilisation (par exemple dans le compartiment moteur d'un véhicule automobile). Cependant, l'évacuation de l'eau pouvant ruisseler sur la face extérieure de la paroi 4 est principalement assurée par une rainure 8 der forme circulaire ou analogue, obtenue par moulage, déformation ou usinage, qui entoure complètement l'ouverture du passage réalisé par le logement 3 et l'orifice 5. Cette rainure présente de préférence une section trapézoïdale définissant un bord périphique évasé 9 facilitant la collecte puis la canalisation autour du bossage 10 ménagé entre la rainure 8 et le logement 3 de l'eau en ruissellement sur la paroi 4 et son évacuation dans la partie inférieure de la rainure.

La figure 3 est une vue en perspective du filtre 2, ici de forme cylindrique comme le logement 3. En variante, le filtre 2 peut avoir toute autre forme appropriée, par exemple sphérique, et le logement 3 une forme complémentaire de celle du filtre. Le filtre 2 en matériau métallique poreux est de préférence réalisé par frittage de poudre métallique de bronze ou d'acier inoxydable par exemple, de sorte qu'il est d'une fabrication peu coûteuse. Le seuil d'arrêt absolu est déterminé en fonction des particules véhiculées. C'est ainsi par exemple que le filtre 2 peut être fritté à partir de billes de bronze de diamètre inférieur ou égal à environ 150 microns ou à partir d'une poudre d'acier inoxydable dont le seuil d'arrêt absolu est inférieur ou égal à environ 30 microns. De son côté, le logement 3 cylindrique peut avoir un diamètre de l'ordre de 5 millimètres et une profondeur inférieure ou égale à environ 5 millimètres.

Ce dispositif échangeur pour boîtier électronique permet un échange d'air constant entre l'extérieur et l'intérieur du boîtier, tout en évitant la condensation et la formation de gouttelettes d'eau pouvant entraîner des courts-circuits, donc un fonctionnement anormal du système électronique enfermé dans le boîtier. La rainure périphérique 8 protège le filtre 2 des ruissellements d'eau de sorte que celui-ci ne requiert pas des caractéristiques d'étanchéité à l'eau sévères et peut être réalisé par un procédé peu coûteux compatible avec une production en grande série.

**Revendications**

1. Dispositif de mise à l'atmosphère pour boîtier électronique, comprenant un passage (3, 5) ménagé dans une paroi (4) du boîtier (1) et mettant en communication l'intérieur et l'extérieur du boîtier (1) et un filtre (2) reçu dans ledit passage, caractérisé en ce qu'il comprend également une rainure périphérique (8) de canalisation de liquide ménagée dans la face extérieure de la paroi (4) et entourant complètement ledit passage (3, 5).

2. Dispositif selon la revendication 1, caractérisé en ce que le filtre (2) est constitué d'un matériau métallique poreux.

3. Dispositif selon la revendication 2, caractérisé en ce que le filtre (2) est réalisé par frittage d'une poudre métallique.

4. Dispositif selon la revendication 3, caractérisé en ce que le filtre (2) est fritté à partir de billes de bronze ayant un diamètre inférieur ou égal à environ 150 microns.

5. Dispositif selon la revendication 3, caractérisé en ce que le filtre (2) est fritté à partir d'une poudre d'acier inoxydable dont le seuil d'arrêt absolu est inférieur ou égal à environ 30 microns.

6. Dispositif selon l'une quelconque des revendications 1 à 5, caractérisé en ce que ledit passage comprend un logement (3) débouchant sur ladite face extérieure de la paroi et dans lequel le filtre (2) est emmanché à force, et un orifice (5) ménagé entre le fond du logement (3) et l'intérieur (6) du boîtier.

7. Dispositif selon la revendication 6, caractérisé en ce que le logement (3) est cylindrique et présente un diamètre de l'ordre de 5 millimètres et une profondeur inférieure ou égale à environ 5 millimètres.

8. Dispositif selon l'une quelconque des revendications 1 à 7, caractérisé en ce que la rainure (8) présente une section trapézoïdale définissant un bord périphérique évasé (9) de collecte et d'évacuation de liquide en ruissellement.

**Patentansprüche**

1. Einrichtung zur Belüftung eines elektronischen Gehäuses, mit einem Kanal (3, 5), der in einer Wand (4) des Gehäuses (1) gebildet ist und das Innere und Äussere des Gehäuses (1) miteinander verbindet, und einem Filter (2), das in dem Kanal untergebracht ist, dadurch gekennzeichnet, dass sie ferner eine Umfangsnut (8) zum Ableiten von Flüssigkeiten aufweist, die in der Aussenseite der Wand (4) gebildet ist und den Kanal (3, 5) vollständig umgibt.

2. Einrichtung nach Anspruch 1, dadurch gekennzeichnet, dass das Filter (2) aus einem porösen metallischen Material besteht.

3. Einrichtung nach Anspruch 2, dadurch gekennzeichnet, dass das Filter (2) durch Sintern eines metallischen Pulvers gebildet ist.

4. Einrichtung nach Anspruch 3, dadurch gekennzeichnet, dass das Filter (2) aus Bronzekugeln gesintert ist, deren Durchmesser kleiner oder gleich ungefähr 150 Mikron ist.

5. Einrichtungen nach Anspruch 3, dadurch gekennzeichnet, dass das Filter (2) aus einem Pulver aus nicht oxidierbarem Stahl gesintert ist, dessen absolute Hemmschwelle kleiner oder gleich ungefähr 30 Mikron ist.

6. Einrichtung nach einem der Ansprüche 1 bis 5, dadurch gekennzeichnet, dass der Kanal eine Aufnahme (3) und eine Öffnung (5) aufweist, von denen die Aufnahme in der Aussenseite der Wand mündet und in die das Filter (2) eingepresst ist und die Öffnung zwischen dem Boden der Aufnahme (3) und der Innenseite (6) des Gehäuses gebildet ist.

7. Einrichtung nach Anspruch 6, dadurch gekennzeichnet, dass die Aufnahme (3) zylindrisch ist und einen Durchmesser in der Grössenordnung von 5 mm und eine Tiefe von ungefähr 5 mm oder weniger hat.

8. Einrichtung nach einem der Ansprüche 1 bis 7, dadurch gekennzeichnet, dass die Nut (8) einen trapezförmigen Querschnitt besitzt, der einen erweiterten Umfangsrand (9) zum Sammeln und Ableiten von Oberflächenflüssigkeit bildet.

**Claims**

1. Venting device for an electronics housing, including a passage (3, 5) provided through a wall (4) of the housing (1) and connecting the inside and the outside of the housing (1) and a filter (2) fitted into the said passage, characterized in that it comprises also a peripheral liquid channeling groove (8) provided in the outside surface of wall (4) and completely surrounding said passage (3, 5).

2. Venting device according to claim 1, characterized in that the filter (2) is made of a porous metallic material.

3. Venting device according to claim 2, characterized in that the filter (2) is obtained by sintering a metallic powder.

4. Venting device according to claim 3, characterized in that the filter (2) is sintered from bronze balls having a diameter of less than or equal to about 150 microns.

5. Venting device according to claim 4, characterized in that the filter (2) is sintered from a stainless steel powder having an absolute barrier threshold less than or equal to about 30 microns.

6. Venting device according to anyone of claims 1 to 5, wherein said passage includes a seating (3) opening on said outside surface of the wall and in which the said filter is force-fitted and an aperture (5) provided between the bottom of the seating (3) and the inside (6) of the housing.

7. Venting device according to claim 6, characterized in that the seating (3) is cylindrical and has a diameter in the order of 5 millimeters and a depth of less than or equal to about 5 millimeters.

8. Venting device according to anyone of claims 1 to 7, characterized in that groove (8) has a trapezoidal cross-section defining a funnel-shaped outer edge (9) for the collection and evacuation of running liquid.

1/1

## FIG.1

## FIG.2

## FIG.3